# EUROPEAN PATENT SPECIFICATION

(11) **EP 4 312 240 B1**
(45) Date of publication and mention of the grant of the patent: **15.04.2026**
(21) Application number: 22187117.1
(22) Date of filing: 27.07.2022
(51) Int. Cl.: H01G 2/06, H01G 11/82, H05K 5/00, H05K 3/30, H01G 2/10, H01G 4/32, H01G 11/78, H01G 4/40

(54) **MOUNTING STRUCTURE FOR A CAPACITOR IN A HOUSING PART OF A HOUSING**
BEFESTIGUNGSSTRUKTUR FÜR EINEN KONDENSATOR IN EINEM GEHÄUSETEIL EINES GEHÄUSES
STRUCTURE DE MONTAGE D'UN CONDENSATEUR DANS UNE PARTIE D'UN BOÎTIER

(43) Date of publication of application: 31.01.2024
(73) Proprietor: Veoneer Sweden Safety Systems AB, 10302 Stockholm (SE)
(72) Inventor: HOMUTESCU, Adrian, 700051 Iasi (RO); SAVIN, Anatolie, 700051 Iasi (RO); CACU, Adrian, 700051 Iasi (RO)
(74) Representative: Reichert & Lindner Partnerschaft Patentanwälte

(56) References cited:
- CN-U- 208 507 463
- DE-U1- 202010 017 072
- JP-A- 2015 035 634
- KR-U- 20120 001 861
- US-A- 6 163 460
- US-A1- 2002 106 939
- US-A1- 2017 352 495
- US-A1- 2019 006 101

## Description

### FIELD OF THE INVENTION

The invention relates to a mounting structure for mounting a capacitor in a housing. part. The housing is defined by a housing part with a bottom and a cover, wherein the mounting structure is an integral part of the bottom of the housing part. The mounting structure is at least defined by a first pair and a second pair of two opposing holding elements for the capacitor.

### DESCRIPTION OF THE BACKGROUND ART

EP 3 240 375 A1 relates to an electronic module for an actuator that can be used in a motor vehicle. The printed circuit board of the electronic module carries at least one cylindrical capacitor and is spaced apart by means of a holding element. The holding element has elastic biased holder cams. The elastic holder cams hold the cylindrical capacitor in a force-fit manner.

DE 10 2012 002 525 A1 discloses a housing structure for a capacitor. The housing structure has a housing base that is provided with a fastening bolt for fastening a housing portion in a slot or for inserting a holder or a plate in an elongated recess. A dimension-side complementary web is extended from the housing base by a surface of the fastening bolt to fix the housing portion in a precise position and to secure against rotation. The fastening bolt is provided with a partially circumferential cantilever portion.

CN 207818380 U discloses an electrolytic capacitor mount.

CN 210575548 U discloses a capacitor installation structure comprising a fixed frame which is an insulator. The fixed frame is fixed on a circuit board. The fixing frame is rectangular, and the shape of the fixing frame is matched with the shape of the capacitor. The capacitor is clamped in the fixed frame. Clamping devices for fixing the capacitor are symmetrically arranged on the inner wall of the fixing frame.

US 2018/242460 A1 describes a connector module for connecting an energy store to a printed circuit board. The connector module is designed in such a way as to receive at least two electrolytic capacitors as energy stores. The connections of the electrolytic capacitors are located at the respective ends of the longitudinal extent of the connector module.

CN 211 828 480 U discloses a fixing structure and an air conditioner compressor assembly, the fixing structure is used for fixing a part to be installed, and the fixing structure comprises an installation plate and a fixing support. The fixing support comprises a base arranged on the mounting plate. A capacitor is fixed through the accommodating space formed by closing the base, the first locking arm and the second locking arm, so that a mode of fixing the capacitor by matching a fixing clamp with a screw is avoided.

JP 2005 123307 A provides a mounting structure for a capacitor with which the capacitor in an arbitrary shape can easily and securely be fix on a substrate. A fixture having a fitting leg and a band connected to the fitting leg is used. The band is wound to the capacitor and the fitting leg and the capacitor are fixed. The fixation with the band is not easy to handle.

US 2009/257199 A1 discloses a connection between an electrolytic capacitor and a circuit board. The capacitor is in a spaced apart manner from the board. The connector module for the capacitor comprises a body with fingers and support members that engage and support the capacitor. The body may feature a plurality of legs, each leg includes spaced-apart members which fit into respective holes in the board. The module has to be produced in a separate process and the support members are not an integral part of a housing part.

CN 208 507 463 U discloses a mounting structure (quick-installed mounting member) for mounting a capacitor. A fixed snap ring has a ring breaking portion formed, and a fixing card bridges ring breaking portion in the snapped position. In the snapped position, the fixed snap ring together with the fixing card surround and secure the capacitor. A mounting card is provided on the outer circumference of fixed snap ring. A structure located at an end portion and at the outside of the mounting card prevents left and right swing.

As known, an electrical control unit (ECU) is an embedded electronic device. A typical ECU consists of a printed circuit board (PCB), a housing part with a bottom, a cover and, in some cases, a backup power unit. It must be ensured that the ECU is supplied with power even in cases where the main power unit has a malfunction. For this reason, the backup power unit is provided, which often is a relatively heavy capacitor. In the case of plastic housings, the fixation of the backup power unit is realized via a mounting structure, also called "cradle", with a plastic snap-fit solution. The mounting structure is an integral part of the bottom of a plastic housing part.

To keep the capacitor in place with prior art devices, the mounting structure (cradle) simply relies on the engagement between the holding elements (plastic snaps) and the capacitor, which means that the holding elements will be loaded with an elastic force to provide the necessary retention force.

The capacitor is assembled in the housing part though a top opening of the holding elements (snaps), by deflecting them outside. The housing is rested on its top surface, so the assembling is done along the Z -direction of the module.

In theory, the prior art concept works great. But, in reality, when considering all the tolerances, the above mentioned engagement can transform into a gap, which may result in a loose capacitor or a rattle noise etc. due to the vibrations during driving. A too consistent engagement may translate in an over-stressed mounting structure (snaps) which leads to plastic (permanent) deformations, creep or fractures etc. A safe and secure mounting of the capacitor in the mounting structure cannot be guaranteed.

A specific challenge for such a device is the so called drop test, that emulates the car hitting or being hit by a large foreign object that can be another car, traffic sign, sidewalk or other similar objects. Such challenges often result in capacitors leaving the cradle.

### SUMMARY OF THE INVENTION

It is an object of the present invention to provide a mounting structure for a capacitor which enables a secure and reliable mounting of the capacitor regardless of drop tests or vibrations while in the same time not exerting a stress on the printed circuit board of the housing.

The above object is achieved by a mounting structure for a capacitor in a housing part of a housing according to the features of claim 1.

According to an embodiment of the present invention, a mounting structure for mounting a capacitor in a housing is provided. The housing is defined by a housing part with a bottom and a cover, wherein the mounting structure is an integral part of the bottom of the housing part. The mounting structure is at least defined by a first pair and a second pair of two opposing holding elements. The mounting structure is characterized by at least one pair of locking features intended to interact with the at least one pair of holding elements to limit an opposing radial defection of the opposing holding elements. The capacitor is thereby secured in the mounting structure of the housing part.

The advantage of the embodiment of the invention is that the cooperation of the pair of holding elements with the pair of locking features secure the capacitor in the mounting structure. The capacitor should stay in the mounted position during a drop test and despite any possible vibrations thus a loosening of the capacitor being avoided.

According to a preferred embodiment each holding element of the second pair is defined by a body and an extension. The extension has a width which is smaller than a width of the body of the holding elements.

The advantage of the embodiment of the invention is that extensions on the second pair of holding elements pass through the holes in the printed circuit board. The design of the extensions save material for the formation of the mounting structure provide the required force for locking the capacitor.

The engagement of the extensions with the locking features will tighten the opposing holding elements (snaps) and provide additional retention force for the capacitor that help the mounting structure to perform as it should do during vibration and drop test. In order to provide the extensions a minimum modification of the holding elements is required.

According to a further embodiment the printed circuit board with through holes is placed in the housing and covered by the cover. Each extension reaches through the through holes of the printed circuit board and abuts on locking features formed as a part of the cover.

The small clearance holes in the printed circuit board allow to lock the holding elements (snaps) by openings on the cover. In this embodiment a stamped cover is shown with two stamped features. Plastic or die cast covers can be used as well with appropriate features to act as locking features for the holding elements (snaps).

Extensions being an integral part of the body of the holding elements of the second pair should be enough to secure the capacitor in the mounting structure. It is clear for a person skilled in the art that the embodiment with extensions only at the second pair should not be regarded as a limitation of the invention. Additionally, there is no contact between the extensions and the holes formed in the printed circuit board, therefore no strain acts on the printed circuit board.

According to a further embodiment of the invention, a printed circuit board has defined through holes. The printed circuit board is placed in the housing and covered by the cover. Free end portions of each extension of the holding elements of the second pair are in engagement with a rim portion of the through holes in the printed circuit board. Each of the free end portions of the extensions has a hook-shaped form which is in contact with a lateral side of the holes of the printed circuit board.

Just like in the first embodiment, the engagement between extensions and the holes of the printed circuit board will provide additional retention force to the holding elements of the mounting structure by means of locking the holding elements from opening, so that the capacitor is securely mounted by the mounting structure. The use of engagement will hold the capacitor tightly when subjected to drop test and vibration. The printed circuit board strain should be negligible as the contact is on the lateral side of the hole, in Y direction.

According to an additional embodiment a printed circuit board is provided with through holes. The printed circuit board is placed in the housing and covered by the cover. A free end portion of each extension of the holding elements of the second pair reaches through the holes and is free within the through holes in the printed circuit board.

If the printed circuit board strain is a concern, the engagement is replaced with a gap between the free end portion of each extension of the holding elements and the rim of the through holes. The advantage of this embodiment is that the capacitor is prevented from escaping the mounting structure when drop tested. The through holes of the printed circuit board act as locking means which limit the opening of the holding elements.

These solutions will not use engagement or interference, so that no stress will be induced in the printed circuit board. For example, the housing (module) is drop tested, the capacitor will tend to escape from the mounting structure, but as the capacitor will move, the gap will be consumed and the capacitor can't move any further. The printed circuit board strain won't represent an issue as the module is not powered during drop test and the strain is momentary.

According to another embodiment, the printed circuit board has mounted locking elements and a side of the free end portions of each extension of the body of the holding elements of the second pair abuts on the locking elements when the printed circuit board is placed in the housing. Finally, the housing is covered by the cover. The locking features reach through defined holes of the printed circuit board.

The advantage is that locking elements can be components of the printed circuit board. The locking elements can interact with the extensions of the holding elements. The components, described here, can be dummy, connectors or even actual components if damaging of the actual components is excluded as a risk.

Nevertheless, for a strong mechanical bond, through hole technology is preferred over surface mount technology. In case of connectors usage, a press fit technology may also be suitable.

According to an additional embodiment of the invention, the cover carries the locking features. The locking features are formed as integral parts of the cover and each locking feature is in contact with a side of the holding elements of the second pair when the cover is attached to the housing part. The locking features reach through defined holes in the printed circuit board.

According to the embodiment described above, instead of having the extensions on the body the holding elements (snaps), long locking features are added on the cover to lock on the body the holding elements. In order to have an interference and provide additional retention force to the mounting structure, the cover has to be made from an elastic or thermo-elastic material, e.g. plastic. If long locking features are suitable to be made on a die cast baseplate, a gap should be maintained to the body of the holding elements, so that the capacitor is prevented from escaping the mounting structure when drop tested because the locking features limit the opening of the body of the holding elements. Additionally, there is no contact between the locking features and the holes of the printed circuit board, therefore no strain is caused on the printed circuit board.

According to a further embodiment a printed circuit board carries locking features mounted thereon. Each locking feature is in relation to a side of the body of each of the holding elements of the second pair when the printed circuit board is attached to the housing part. The locking features limit a movement of the body of the holding elements in a radial direction way from the capacitor.

The locking features, mounted on the printed circuit board, are taller components as in previous described embodiments. The locking features are used to act on the body of each of the holding elements without the help of extensions, which are part of the holding elements. This embodiment makes more sense to be used when the capacitor is placed closer to the printed circuit board.

A gap could be established between the body of the holding elements of the mounting structure and the locking features on the printed circuit board. With the gap there is no interference between the body of the holding elements and the locking features, but a movement of the body of the holding elements in a radial direction away from the capacitor is limited. In case the locking features show some elasticity an interference with the body of the holding elements can be introduced and the locking features provide additional retention force to the mounting structure.

According to an additional embodiment the body of two opposing holding elements of at least the second pair can have a flexed form and is defined by a first segment, a second segment and a third segment. The holding elements are arranged such on the base of the housing cover that a distance between the first segments of the holding elements is larger than a distance between the third segments of the holding elements. Each of the third segments carries the extension.

The extension of the holding elements passes through respective holes in the printed circuit board and free end portions of the extensions are aligned with respective locking features of the cover. The mounted cover exerts a first force perpendicular to the bottom of the housing part and thereby deforming the holding elements (closing the gap between the capacitor and the body of the holding elements) and exerting a second force on the capacitor. The gap between the body of the holding elements and the capacitor will be consumed during assembly, due to the interference between the free ends of the extensions of the holding elements and the cover and consequently the capacitor will be hold tightly in the mounting structure.

Considering the fact, that the holding elements of the new design don't rely on the elastic force as the regular holding elements or bodies of the holding elements, it is rather the pressure from the cover which creates elastic forces and normal forces. This is valid all the embodiments which use interference and thereby provide additional retention force to the mounting structure so that the capacitor does not escape from the mounting structure.

The interference between the endings of holding elements and the cover will introduce normal forces. This will cause the holding elements to bend, a gap between the holding elements and the capacitor will be consumed and new normal forces will emerge at the contact with the capacitor. These forces will hold the capacitor tight in the mounting structure.

According to some embodiments of the invention, locking features on the cover can be added to prevent holding elements shifting around once pressure is applied and holding elements start to deform. In case the printed circuit board can handle the pressure or force, the holding elements can be shorter.

The embodiments described above can be modified and combined as follows:
- Only one extension on the body of the holding element, one locking feature on the cover, a single hole in the printed circuit board, one locking feature on the printed circuit board to be used if it can be demonstrated that the required retention force is achieved to the mounting structure. The advantage relies in simplification, a bit of cost saving, more space on the printed circuit board etc. The disadvantage is the introduction of an asymmetry between the holding element, but, if manageable, the advantages are considerable.
- Both set of bodies of holding elements have extensions and all the additional features that come with this.
- One set of holding elements can be deleted if the retention force provided by the embodiments disclosed herein is enough, to achieve a safe and secure mounting of the capacitor in the mounting structure.

There is a series of advantages over the prior art provided by the present invention. There is no need to rely just on the force provided by the prior art holding elements to hold the capacitor in place in the mounting structure. Additionally, no change in the overall architecture of the product, no or minimum changes to the mounting structure or the housing part, cover or printed circuit board. There is no change to the mould design which does not cause a cost increase. Moreover, the new embodiments do not require a change in the current assembly process, no added assembly steps. Pressure on the baseplate is anyway applied during screwing operation in case of sealed modules.

The proposed embodiments have minimum or no impact on the available space of the printed circuit board, because only two holes or two dummy components are added. The available space of the printed circuit board for a regular restrain module will decrease with only 0.5 - 1%, so it's negligible.

According to some embodiments the advantage is that there is no contact with the printed circuit board, if inducing stress on the printed circuit board and affecting of the Mechanical Transfer Function performance are considered risks.

### BRIEF DESCRIPTION OF THE DRAWINGS

The numerous advantages of the disclosure may be better understood by those skilled in the art by reference to the accompanying figures in which:
Figure 1 shows a schematic representation of the placement of an electronic control unit (ECU) in a vehicle.
Figure 2 is a perspective view of an embodiment of a prior art capacitor cradle (for example, being an integral part of a plastic housing).
Figure 3 is a perspective, sectional view along line A-A of Fig. 2, wherein a capacitor is placed in the prior art cradle.
Figure 4 is a front, sectional view along line A-A of Fig. 2, wherein a capacitor with a minimum allowed diameter tolerance is placed in the prior art cradle.
Figure 5 is a front, sectional view along line A-A of Fig. 2, wherein a capacitor with a maximum allowed diameter tolerance is placed in the prior art cradle.
Figure 6 is a table showing the pull-out force of capacitors having different diameters.
Figure 7 is a table showing the resulting snap force of holding elements of a mounting structure (cradle) in a Y-direction, wherein the capacitors have different diameters.
Figure 8 is a view of capacitor escaping from the mounting structure (cradle) according to a prior art mount.
Figure 9 is a perspective view of the housing part with mounting structure (cradle) for the capacitor, wherein mounting structure is an integral part of the bottom of the housing part.
Figure 10 is an enlarged front and cut away view of an embodiment of the housing wherein the capacitor is locked in the mounting structure of the housing part.
Figure 11 is a perspective and cut away view of the embodiment of the housing as shown in Fig. 10.
Figure 12 is an enlarged sectional front view of a further embodiment of the mounting structure (cradle) according to the invention for locking the capacitor in the mounting structure.
Figure 13 is an enlarged perspective view of the embodiment of Fig. 12 of the mounting structure (cradle) for the capacitor.
Figure 14 is an enlarged front view of an alteration of the embodiment of the mounting structure (cradle) according to the invention of Fig. 12 for locking the capacitor in the mounting structure.
Figure 15 an enlarged perspective view of the capacitor mounting shown in Fig. 14.
Figure 16 is an enlarged front view of an additional embodiment of the mounting structure (cradle) according to the invention for locking the capacitor in the mounting structure.
Figure 17 is an enlarged perspective view of the embodiment shown in Fig. 16.
Figure 18 is an enlarged front view of an additional embodiment of the mounting structure (cradle) according to the invention for locking the capacitor in the mounting structure.
Figure 19 is an enlarged perspective view of the embodiment shown in Fig. 18.
Figure 20 is an enlarged front view of an additional embodiment of the mounting structure (cradle) according to the invention for locking the capacitor in the mounting structure.
Figure 21 is an enlarged perspective view of the embodiment shown in Fig. 20.
Figure 22 is an enlarged front view of a further embodiment of the mounting structure (cradle) according to the invention for locking the capacitor in the mounting structure.
Figure 23 is an enlarged perspective view of the embodiment shown in Fig. 21.
Figure 24 is an enlarged front view of an embodiment of the mounting structure (cradle) according to the invention, similar to the embodiment as shown in Fig. 22, for locking the capacitor in the mounting structure.
Figure 25 is an enlarged perspective view of the embodiment shown in Fig. 24.
Figure 26 is an enlarged front view of the embodiment of Fig 22 wherein the cover of the housing is not in the final mounting position.
Figure 27 is an enlarged front view of the embodiment of Fig 22 wherein the bottom of the housing is in the final mounting position.

### DETAILED DESCRIPTION

In the ensuing description, numerous specific details are provided to enable maximum understanding of the embodiments that are provided by way of example. The embodiments may be implemented with or without specific details, or else with other methods, components, materials, etc. In other circumstances, well-known structures, materials, or operations are not illustrated or described in detail so that various aspects of the embodiments will not be obscured. Reference in the course of the present description to "an embodiment" or "one embodiment" means that a particular structure, peculiarity, or characteristic described in connection with its implementation is comprised in at least one embodiment. Hence, phrases such as "in an embodiment" or "in one embodiment" that may recur in various points of the present description do not necessarily refer to one and the same embodiment. Furthermore, the particular structures, peculiarities, or characteristics may be combined in any convenient way in one or more embodiments.

Same reference numerals refer to same elements or elements of similar function throughout the various figures. Furthermore, only reference numerals necessary for the description of the respective figure are shown in the figures. The shown embodiments represent only examples of how the invention can be carried out. This should not be regarded as a limitation of the invention, the scope of which is defined by the appended claims.

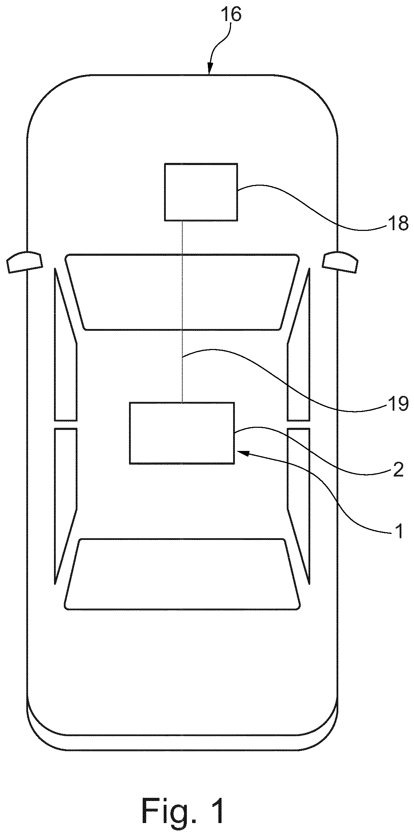

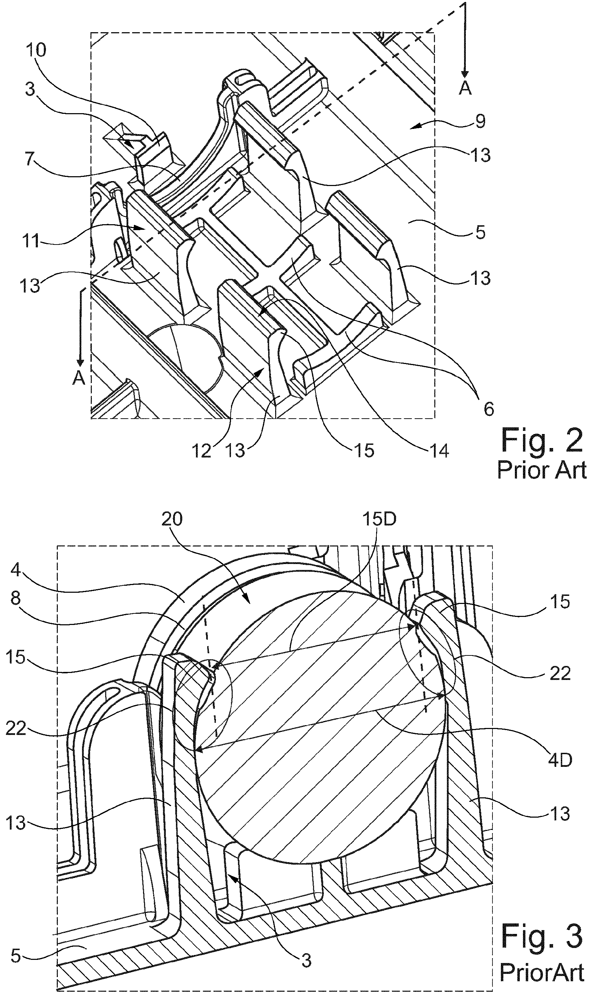

**Figure 1** shows a schematic representation of an embodiment of a placement of an electronic control unit (ECU) **1** for a vehicle **16.** Electronic control unit **1** controls one or more electrical systems of vehicle **16** and is enclosed by a housing **2.** Housing **2** may be made of plastic or metallic materials. In cases where vibrations are more extreme during use of vehicle **16,** housing **2** may be made of metallic materials, such as die-cast aluminium. To supply electrical power to ECU **1,** ECU **1** is electrically connected to a vehicle battery **18** (main battery), typically by an electric line **19.** To ensure a durable supply of electric power to the ECU **1** backup power unit, which is a capacitor (see Fig. 3). The relatively heavy capacitor must be mounted in the housing **2** of the ECU **1,** so that backup power supply is guaranteed in all traffic situations.

**Figure 2** shows a perspective view of an embodiment of a prior art mounting structure **3** (cradle) for a capacitor **4** (see Fig. 3). In the embodiment shown here, the mounting structure **3** is an integral part of a housing part **9.** In case the housing part **9** is made of plastic, the mounting structure **3** is formed during the injection moulding process to the housing part **9.** The mounting structure **3** has several support surfaces **6,** which are provided on a bottom **5** of housing part **9** and the capacitor **4,** in the mounted state, rests in the support surfaces **6.** An alignment support **7** is as well an integral part of the mounting structure **3.** Once the capacitor **4** is positioned in the mounting structure **3,** the alignment support **7** is in a form fitting contact with a circumferential notch **8** (see Fig. 3) of capacitor **4.** Circumferential notch **8** enables a correct positioning of capacitor **4** in the mounting structure **3.**

At least a first pair **11** and a second pair **12** of holding elements **13** extend upright from the bottom **5** of mounting structure **3** or the bottom of housing part **9.** A nose **15** is provided at a free end **14** of each holding element **13.** The noses **15** of the first pair **11** of holding elements **13** and the noses **15** of the second pair **12** of holding elements **13** face each other. The holding elements **13** are elastic and keep the capacitor **4** in place. The kind of mounting structure **3,** shown here, simply relies on the interference between the holding elements **13** (e.g., plastic snaps) and the capacitor **4,** which means that the holding elements **13** of the mounting structure **3,** loaded with an elastic force by the insertion of capacitor **4** into cradle **3,** provide a necessary retention force for capacitor **4.**

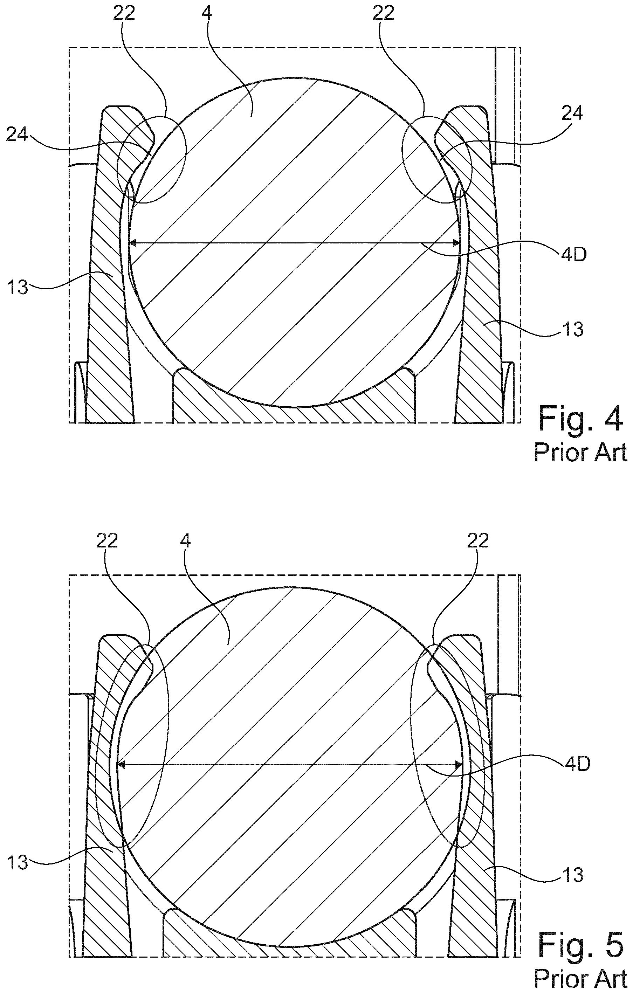

**Figure 3** is a perspective, sectional view along line A-A of Fig. 2, wherein capacitor **4** is placed in prior art mounting structure **3.** Here, only the noses **15** of the two opposing holding elements **13** of the first pair **11** of holding elements **13** are shown. The noses **15** of the two opposing holding elements **13** are spaced apart at a distance **15D,** even with the inserted capacitor **4,** which has a diameter smaller than diameter **4D** of capacitor **4.** During the insertion of capacitor **4** into mounting structure **3,** the two opposing holding elements **13** are pushed apart, and once capacitor **4** is in its final position, as shown here, the opposing holding elements **13** exert a retention force on a surface **20** of capacitor **4.** Accordingly, a portion of each holding element **13** abuts against the surface **20** of capacitor **4,** and in particular, against surface **20** in the marked areas **22** in Fig. 3. In theory, the prior art concept works great. In reality, however, when considering all the tolerances (capacitor **4** diameter **4D** or distance between two opposing holding elements **13),** the above mentioned tolerances can turn into a gap (see Fig. 5) which loosens the capacitor **4** and causes rattle, noise etc. - or, in case of too big tolerance deviations (see Fig. 5), may translate into over-stressed holding elements **13** (plastic snaps) in plastic (permanent) deformations, creep, fractures or the like.

In theory, the above concept works great. However, when considering the tolerances of diameter **4D** (see Fig. 3) of capacitor **4,** the abutment of each holding element **13** can transform into a gap **24,** as shown in **Figure 4** by marked areas **22.** Here, the diameter **4D** of capacitor **4** is at a minimum, and consequently the capacitor **4** may become loose, cause a rattling noise, or the like.

**Figure 5** shows the situation in which the diameter **4D** of capacitor **4** is at a maximum. Consequently, the interference or the abutment of the opposing holding elements **13** translate in over-stressed holding elements **13,** plastic (permanent) deformations, creep, fractures, or the like, of holding elements **13.** The areas with over-stress between capacitor **4** and holding elements **13** are the marked areas **22.** In contrary to Fig. 4, no gap **24** is formed.

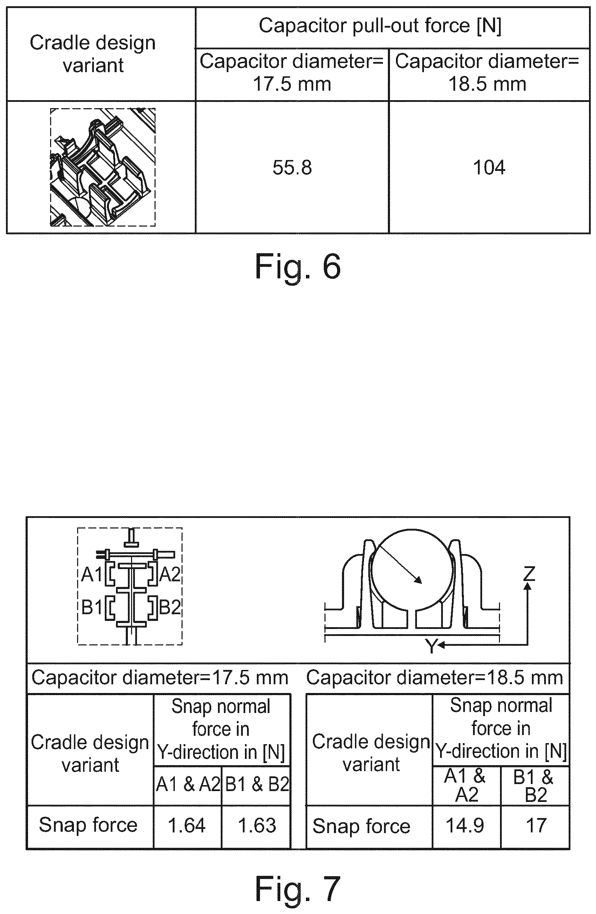

**Figure 6** represents a table, showing the pull-out force of a capacitor **4** from the prior art mounting structure **3** design (cradle design) as shown in the presented table. The considered mounting structure **3** has the minimum distance **15D** of 14.8 mm between the noses **15** of the first pair **11** and second pair **12** of opposing holding elements **13.** For the determination of the pull-out force for capacitor **4,** the two worst cases of the diameter 4D of capacitor **4** were considered (minimum diameter = 17.5 and maximum diameter = 18.5mm). The capacitor **4** pull-out force is almost half for the capacitor **4** minimum diameter **4D** compared with the capacitor **4** with the maximum diameter **4D.**

**Figure 7** is a table showing the resulting snap force of holding elements **13** (snaps) of a mounting structure (cradle) **3** in a Y-direction, wherein the snap force is calculated with a capacitor **4** of differing diameters **4D.** The normal force (snap force) between the opposing holding elements **13** (snaps) and the capacitor **4** is considerable for the capacitor **4** with maximum diameter **4D.** The normal force between the opposing holding elements **13** A1 and A2 results in 14.9 N and between the opposing holding elements **13** B1 and B2 results in 17 N. For the capacitor **4** with the minimum diameter **4D,** the normal force between the opposing holding elements **13** A1 and A2 results in 1.64N and between the opposing holding elements **13** B1 and B2 results in 1.63 N. The low forces which exist if a capacitor **4** with the minimum diameter **4D** is mounted in the mounting structure **3** (cradle) will cause the capacitor **4** to rattle at low frequency and thus causing the module to resonate.

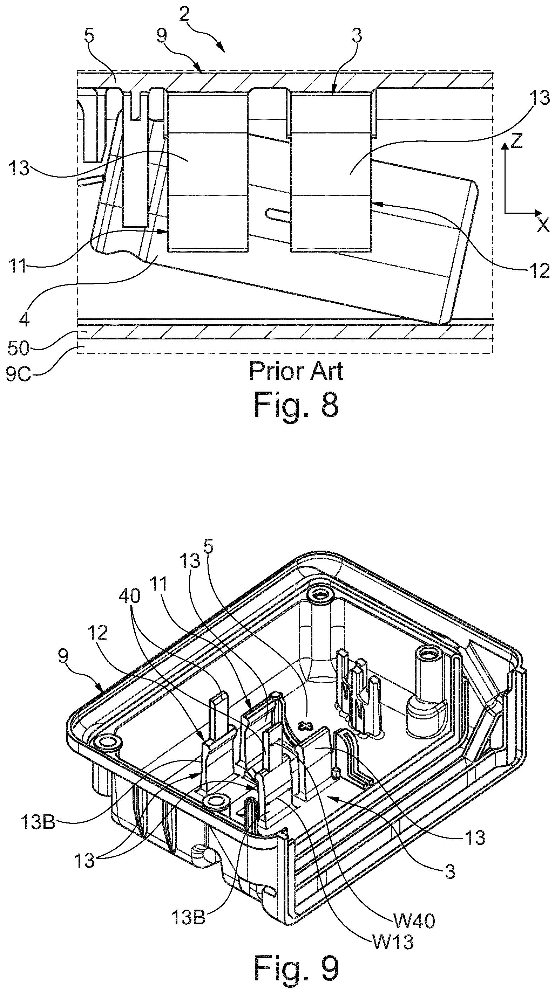

**Figure 8** is a view of the capacitor **4** escaping from the mounting structure **3** (cradle) according to a prior art mount. The prior art embodiment of mounting structure **3** has a first pair **11** of holding elements **13** and a second pair **12** of holding elements **13** for mounting the capacitor **4** inside the housing 2. The mounting structure **3** is an integral part of the bottom **5** of the housing part **9,** wherein the housing part **9** functions as cover **9C** for the bottom **5.** In case of a drop test, the prior art design of the mounting structure **3** cannot always avoid that the heavy capacitor **4** drops in a Z-direction **Z** onto a printed circuit board **50** on the bottom **5** of the housing **2.**

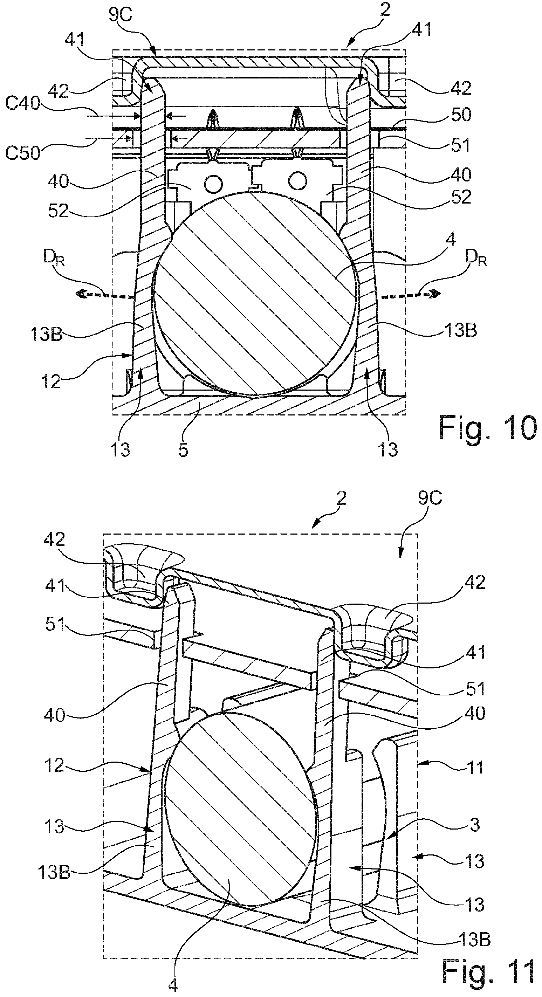

**Figure 9** is a perspective view of one possible embodiment of the housing part **9** which is flipped 180° compared to Fig. 8. The bottom **5** of the housing part **9** carries the mounting structure **3** (cradle). The mounting structure **3** comprises a first pair **11** of holding elements **13** (snaps) and a second pair **12** of holding elements **13** (snaps) of the mounting structure **3.** In the embodiment shown here, each holding element **13** of the second pair **12** of holding elements **13** is defined by a holding element body **13B** and an extension **40** formed thereon. Here, the extensions **40** are only part of the holding elements **13** of the second pair **12.** This embodiment is considered sufficient to retain the capacitor **4** in the mounting structure **3** (cradle). It is well understood for any person skilled in the art that the extensions **40** may also be part of the first pair **11** of holding elements **13** or the holding elements **13** of the first pair **11** and the second pair **12** each carries the extension **40** formed thereon. According to the embodiment shown here, the extensions **40** formed on the holding element body **13B** have a width **W40** which is smaller than the width **W13** of the holding element body **13B.** Consequently, the cross section of the extensions **40** should be as small as possible so that the extensions **40** can reach through holes **51** in the printed circuit board **50** (see, for example, Figs. 10 and 11).

A possible embodiment according to the invention is shown in **Figures 10** and **11.** Fig. 10 is an enlarged front and cut away view of an embodiment of the housing **2** wherein the capacitor **4** is locked in the mounting structure **3** of the housing part **9.** Fig. 11 is a perspective cut away view of the embodiment of the housing **2** as shown in Fig. 10. According to the embodiment, as shown in Figs. 10 and 11, the second pair **12** of the holding elements **13** of the mounting structure **3** (cradle) for the capacitor **4** is defined by a holding element body **13B** and an extension **40** integrally formed thereon. Once the capacitor **4** is in the mounting structure **3,** a current linkage **52** provides the electrical connection between the capacitor **4** and the printed circuit board **50.**

The integrally formed extensions **40** are dimensioned such that each extension **40** passes through respective holes **51** of the printed circuit board **50.** At least one pair of locking features **42** of the cover **9C** interact with the at least one pair of extensions **40** to secure the capacitor **4** in the mounting structure **3.** The cross section **C50** of the hole **51** in the printed circuit board **50** is larger than the cross section **C40** of the extensions **40.** The mounting structure **3** is an integral part of the bottom **5** of the housing part **9.** The locking features **42** of the cover **9C** come into contact with the extensions **40** during the mounting process of the cover **9C** to the housing part **9.** The extensions **40** move easily through the holes **51** in the printed circuit board **50** and do, due to the size of the holed **51,** not interact with the printed circuit board **50.** A respective free end portion **41** of each extension **40** abuts against the locking features **42** of the cover **9C,** thereby locking the holding elements **13** and securing the capacitor **4** in the mounting structure **3.**

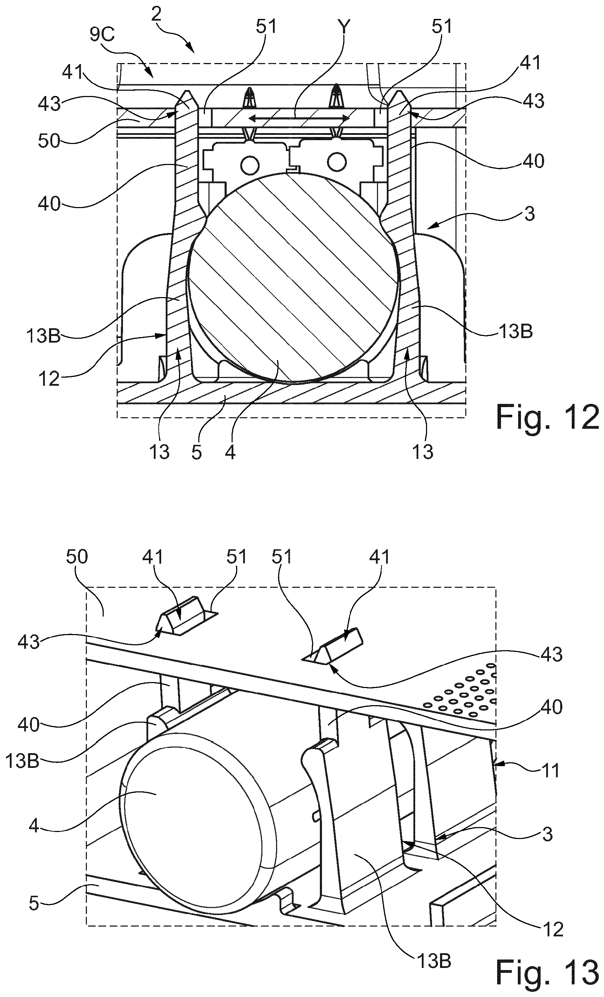

**Figures 12** and **13** show enlarged views of another possible embodiment according to the invention. Fig. 12 is an enlarged sectional front view of a further embodiment of the mounting structure **3** (cradle) according to the invention for locking the capacitor **4** in the mounting structure **3.** Fig. 13 is an enlarged perspective view of the embodiment of Fig. 12. The embodiment shown here differs from the embodiment shown in Figs. 10 and 11 in that the free end portions **41** of each extension **40** of the holding elements **13** of the second pair **12** are in engagement with the through holes **51** in the printed circuit board **50.** Each of the free end portions **41** of the extensions **40** has a hook-shaped form **43** which is in contact with a lateral side of the holes **51** of the printed circuit board **50** in the Y-direction Y and the opposite Y-direction Y, respectively. The strain on the printed circuit board **50** should be neglectable in this embodiment, since the extensions **40** contact only a lateral side of the holes **51.** The extensions **40** block a separation of the holding elements **13** of the second pair **12** and as a result, the capacitor **4** cannot escape from the mounting structure **3** on the bottom **5** of the housing part **9.**

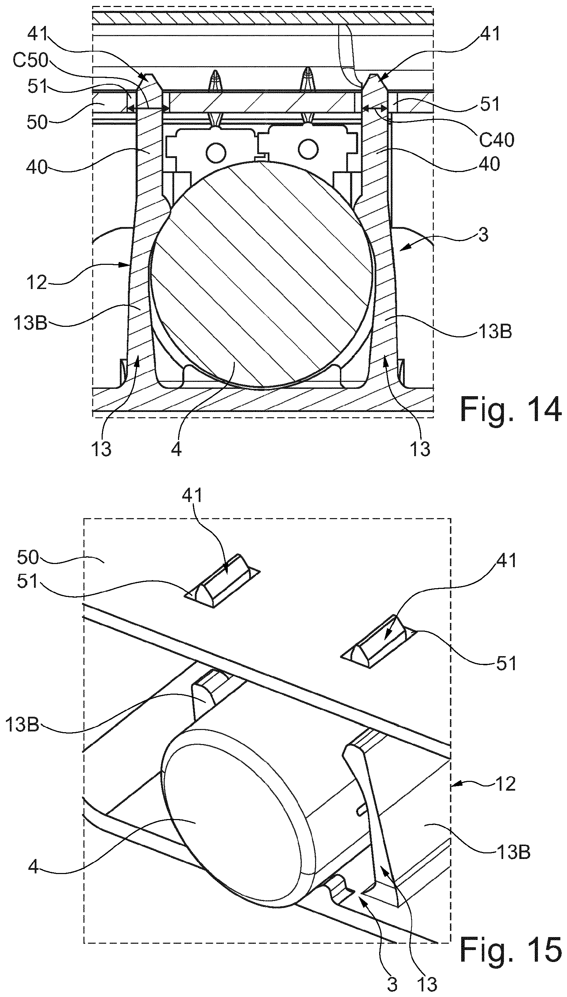

**Figures 14** and **15** show enlarged views of a further embodiment according to the invention. Fig. 14 is an enlarged sectional front view of the further embodiment of the mounting structure **3** (cradle) according to the invention for locking the capacitor **4** in the mounting structure **3.** Fig. 15 is an enlarged perspective view of the embodiment of Fig. 14. As already described with regard to the embodiment shown in Fig 10 and Fig. 11, the extensions **40,** integrally formed on the body **13B** of the holding elements **13,** are dimensioned such that each extension **40** passes through respective holes **51** of the printed circuit board **50.** The cross section **C50** of the hole **51** in the printed circuit board **50** is larger than the cross section **C40** of the extensions **40** (see Figs. 10 to 11). Compared to the embodiment shown in Figs. 12 and 13, the free end portion **41** of the extensions **40** do not contact the sides of the holes **51** in the printed circuit board **50.** Nevertheless, the mounting concept for the capacitor **4** according to the embodiment shown here works as well. For example, in case the housing **2** is drop tested, the capacitor **4** will tend to escape from the mounting structure **3.** The capacitor **4** will start to move, and, as a consequence of this movement, the free end portions **41** of the extensions **40** abut with sides of the holes **51** provided in the printed circuit board **50.** The abutment of free end portions **41** of the extensions **40** block any further movement of the capacitor **4.** A strain on the printed circuit board **50** is not an issue as the electric circuits (not shown) are not powered and the strain exerted on the printed circuit board **50** acts only during a short period of time.

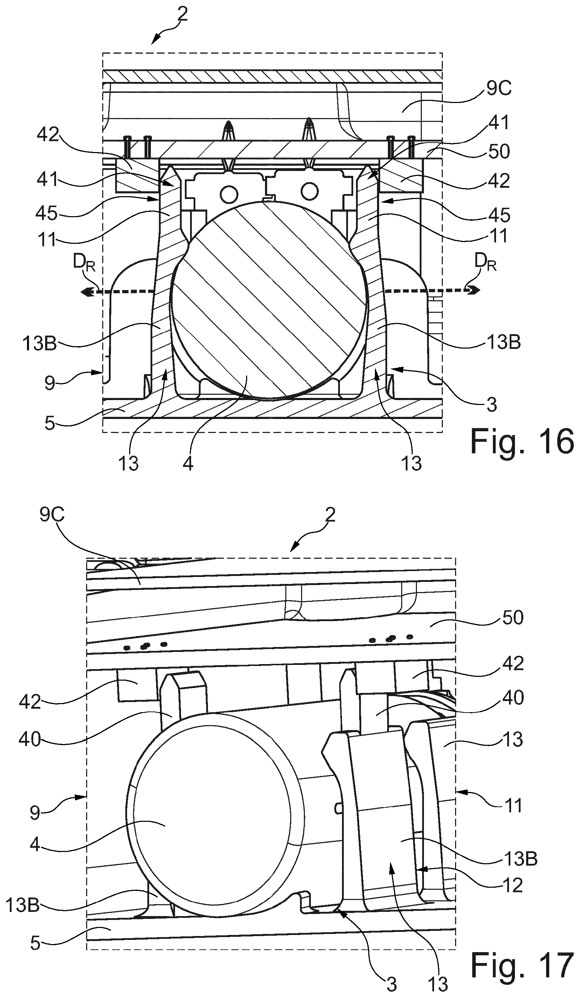

**Figures 16** and **17** show enlarged views of an additional embodiment according to the invention. Figure 16 is an enlarged front view of an additional embodiment of the mounting structure **3** (cradle) according to the invention for locking the capacitor **4** in the mounting structure **3.** Figure 17 is an enlarged perspective view of the embodiment shown in Fig. 16. The printed circuit board **50** has locking features **42** mounted which are placed in the housing **2** when the printed circuit board **50** is mounted to the housing part **9.** The housing part **9** is covered by the cover **9C.** The contact of the locking features **42** with the side **45** of the free end portions **41** of each extension **40** of the body **13B** of the holding elements **13** prevents a movement of the holding elements **13** in opposite radial directions **D_{R}** of the holding elements **13** away from the capacitor **4.** With this construction, the capacitor **4** is as well securely fixed in the mounting structure **3.**

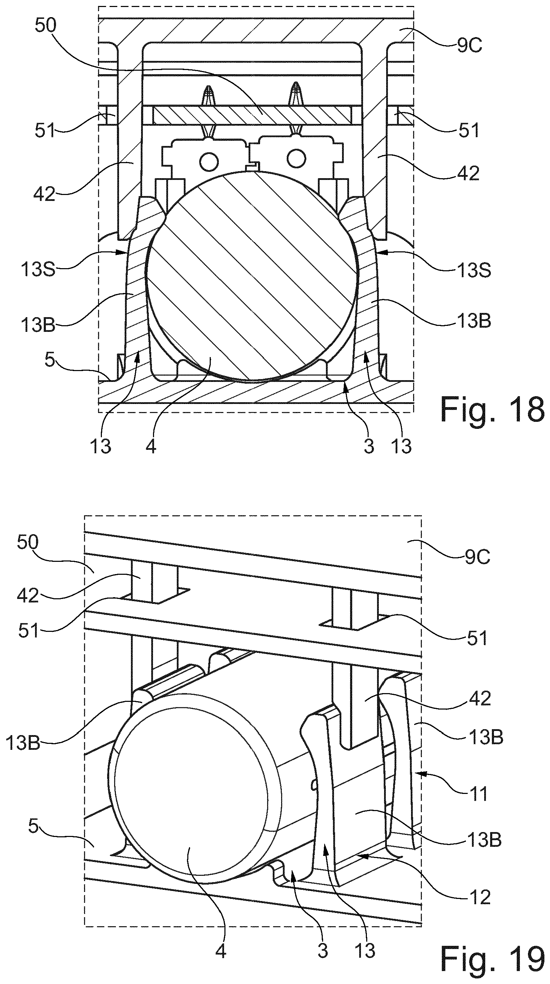

**Figures 18** and **19** show enlarged views of an additional embodiment according to the invention. Figure 18 is an enlarged front view of an additional embodiment of the mounting structure **3** (cradle) according to the invention for locking the capacitor **4** in the mounting structure **3.** Figure 19 is an enlarged perspective view of the embodiment shown in Fig. 18. In the embodiment shown here, the cover **9C** carries the locking features **42** which are formed thereon and are an integral part of the cover **9C.** Each locking feature **42** is in contact with a respective side **13S** of the body **13B** of the holding elements **13** of the second pair **12** when the cover **9C** is attached to the housing part **9.** The locking features **42** of the attached cover **9C** reach thereby through defined holes **51** of the printed circuit board **50.** Here as well, the contact of the locking features **42** with the side **13S** of the body **13B** of the holding elements **13** prevents a movement of the holding elements **13** in a radial direction **D_{R}** (see for example Fig. 16) of the holding elements **13** away from the capacitor **4.** With this construction, the capacitor **4** is securely fixed in the mounting structure **3.**

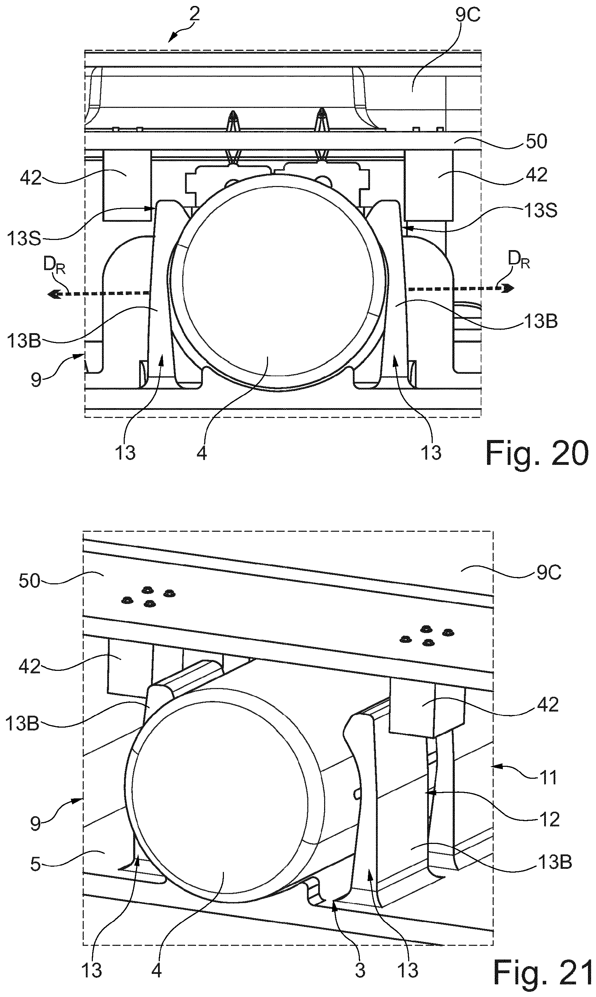

**Figures 20** and **21** show enlarged views of one more embodiment according to the invention. Figure 20 is an enlarged front view of an embodiment of the mounting structure **3** (cradle) according to the invention for locking the capacitor **4.** Figure 21 is an enlarged perspective view of the embodiment shown in Fig. 20. Here the printed circuit board **50** carries mounted locking features **42.** Each locking feature **42** is in cooperation with a respective side **13S** of the body **13B** of each of the holding elements **13** of the second pair **12** when the printed circuit board **50** is attached to the housing part **9.** Here as well, a contact between the locking features **42** and the side **13S** of the holding elements **13** prevents a movement of the holding elements **13** in a radial direction **D_{R}** (see for example Fig. 16) of the holding elements **13** away from the capacitor **4.** With this construction, the capacitor **4** is securely fixed in the mounting structure **3.**

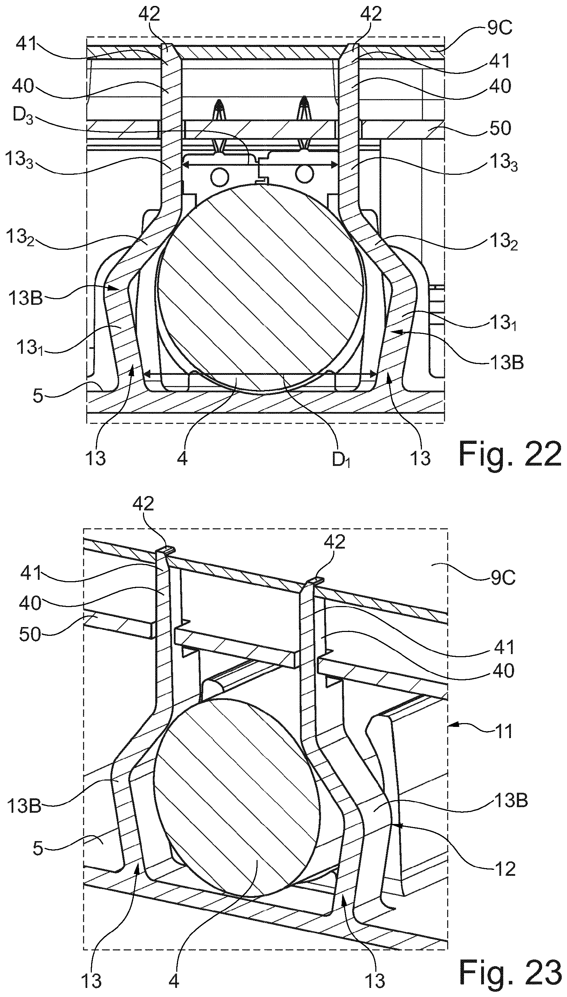

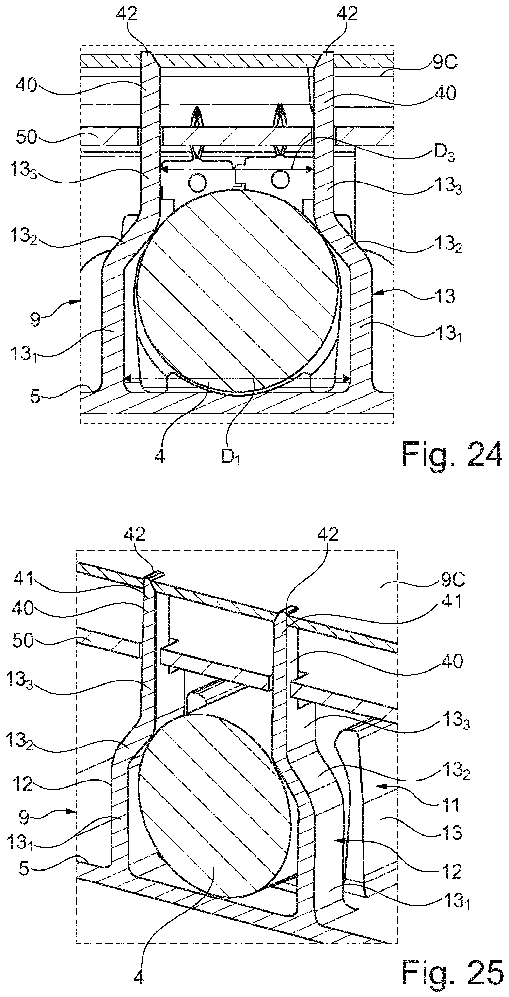

**Figures 22** and **23** show enlarged views of one more embodiment according to the invention. Figure 22 is an enlarged front view of a further embodiment of the mounting structure (cradle) according to the invention for locking the capacitor **4** in the mounting structure **3.** Figure 23 is an enlarged perspective view of the embodiment shown in Fig. 22. The two opposing holding elements **13** of at least the second pair **12,** as shown as well in the embodiments of **Figures 24** and **25****,** have a flexed form, each of which defining a first segment **13₁**, a second segment **13₂** and a third segment **13₃**. The distance **D₁** between the first segments **13₁** of the holding elements **13** is larger than the distance **D₃** between the third segments **13₃**, and each of the third segments **13₃** carries the extension **40.** As already mentioned in the description of Fig. 9, the extensions **40** are formed on each of the third segment **13₃** of the body **13B** of the holding elements **13,** wherein the extensions **40** have a width **W40** which is smaller than the width **W13** (see Fig. 9) of the body **13B** of the holding elements **13.** Consequently, the cross section of the extensions **40** should be as small as possible so that the extensions **40** can reach through holes **51** in the printed circuit board **50** (see, for example, Figs. 22 to 25). As shown in Figs. 22 to 25, the cover **9C** is not in the final mounting position in the housing part **9.** Each extension **40** has a tapered free end portion **41.** The cover **9C** has corresponding locking means **42,** which match in a form fitting manner with the tapered free end portion **41** of the extensions **40.**

The difference between the embodiment shown in Figs. 22, 23 and the embodiment shown in Figs. 24, 25 is the orientation of the first segment **13₁** of the holding element **13.** In Figs. 22 and 23, the orientation of the first segment **13₁** of the holding element **13** is angled away from the capacitor **4** (not perpendicular to the bottom **5** of the housing part **9).** In Figs. 24 and 24 the orientation of the first segment **13₁** of the holding element **13** is essentially perpendicular to the bottom **5** of the housing part **9.**

The difference between the embodiment shown in Fig. 22 to 23 and the embodiment shown in Fig. 24 to 25 is that the housing part **9** with the mounting structure **3** is easier to mould and the holding element **13** does not need to be deformed during unmoulding.

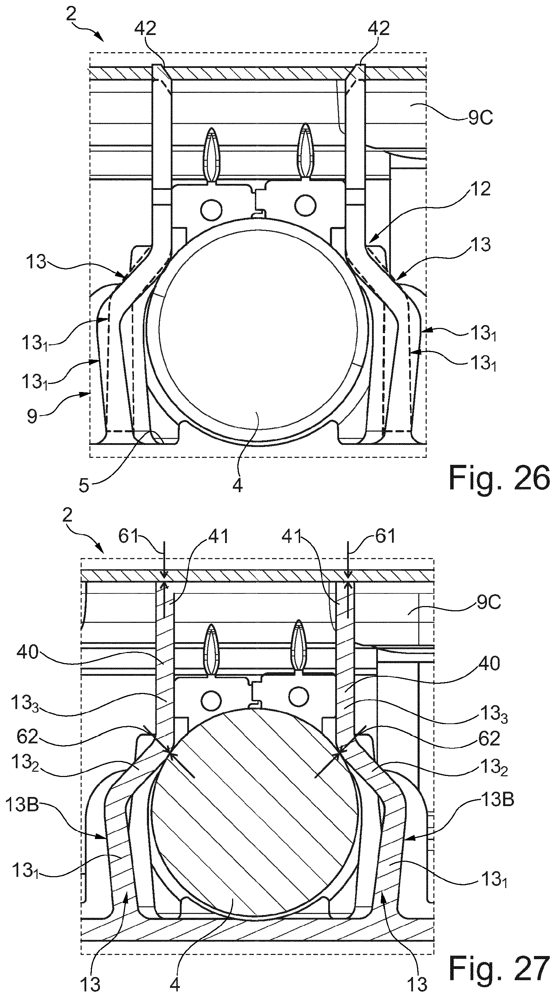

**Figure 26** is an enlarged front view of the embodiment of Fig 24 (first segment **13₁** of the holding element **13** is perpendicular to the bottom **5** of the housing part **9),** wherein the cover **9C** of the housing **2** is not in the final mounting position to the housing part **9.** Additionally, Fig. 26 shows the overlap of the undeformed holding elements **13** of the second pair **12** and the deformed holding elements **13** of the second pair **12** if the cover **9C** of the housing **2** is completely attached to the housing part **9.**

**Figure 27** is an enlarged front view of the embodiment of Fig 24 wherein the cover **9C** of the housing **2** is in the final mounting position. Here the tapered free end portion **41** of each extension **40** is at least in form fitting manner with the corresponding locking elements **42** of the cover **9C.** The engagement between the free end portions **41** and the corresponding locking elements **42** (see Fig. 26) introduce a first force **61** (normal force) on the free end portions **41** and the third segment **13₃** of the body **13B** of each of the holding elements **13.** The first force **61** causes the first segments **13₁** of the base **13B** of the holding elements **13** to bend away from the capacitor **4,** and thereby the second segment **13₂** closes the gap (not shown) between the capacitor **4** and each second segment **13₂** of the base **13B** of the holding element **13.** The exerted second **62** force holds the capacitor **4** in the mounting structure **3.**

It is believed that the present disclosure and many of its attendant advantages will be understood by the foregoing description, and it will be apparent that various changes may be made in the form, construction, number and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### List of Reference Numerals

- 1: Electronic control unit (ECU)
- 2: Housing
- 3: Mounting structure, cradle
- 4: Capacitor
- 4D: Capacitor diameter
- 4E: Front end
- 5: Bottom
- 6: Support elements
- 6S: Surface form
- 7: Alignment support
- 8: Circumferential notch
- 9: Housing part
- 9C: Cover
- 10: Limit stop
- 11: Fist pair
- 12: Second pair
- 13: Holding element
- 13₁: first segment
- 13₂: second segment
- 13₃: third segment
- 13B: Body of holding element
- 13S: Side
- 14: Free end
- 15: Nose
- 15D: Distance
- 16: Vehicle
- 18: Vehicle battery
- 19: Electric line
- 20: Surface
- 22: Area
- 24: Gap
- 30: Electric lead
- 32: Seat
- 34: Guide
- 34S: Surface form
- 35: Free end
- 40: Extension
- 41: Free end portion
- 42: Locking feature
- 43: Hook-shaped form
- 45: Side
- 50: Printed circuit board
- 51: Hole
- 52: Current linkage
- 61: First force
- 62: Second force
- A1: Holding element
- A2: Holding element
- B1: Holding element
- B2: Holding element
- C40: Cross section
- C50: Cross section
- D1: Distance
- D3: Distance
- D_{R}: Radial deflection
- W13: Width
- W40: Width
- X: X-direction
- Y: Y-direction
- Z: Z-direction

## Claims

1. A mounting structure (3) for mounting a capacitor (4) in a housing (2)
**characterized by**
a housing part (9) of the housing (2) with a bottom (5) and a cover (9C),
wherein the mounting structure (3) is an integral part of the bottom (5) of the housing part (9) and
the mounting structure (3) is at least defined by a first pair (11) and a second pair (12) of two opposing holding elements (13) for the capacitor (4),
at least one pair of locking features (42) interacting with the at least one pair of holding elements (13) to limit a radial defection (D_{R}) of the opposing holding elements (13) and thereby securing the capacitor (4) in the mounting structure (3).

2. The mounting structure (3) according to claim 1, wherein each holding element (13) of the second pair (12) is defined by a body (13B) and an extension (40), wherein the extension (40) has a width (W40) which is smaller than a width (W13) of the body (13B) of the holding elements (13).

3. The mounting structure (3) according to claims 1 or 2, wherein a printed circuit board (50) with through holes (51) is placed in the housing (2) and covered by the cover (9C), wherein each extension (40) reaches through the through holes (51) and abuts on locking features (42) formed as a part of the cover (9C).

4. The mounting structure (3) according to claims 1 or 2, wherein a printed circuit board (50) with through holes (51) is placed in the housing (2) and covered by the cover (9C), wherein a free end portions (41) of each extension (40) of the holding elements (13) of the second pair (12) are in engagement with the through the holes (51) in the printed circuit board (50).

5. The mounting structure (3) according to claim 4, wherein each of the free end portions (41) of the extensions (40) has a hook-shaped form (43) which is in contact with a lateral side of the holes (51) of the printed circuit board (50).

6. The mounting structure (3) according to claims 1 or 2, wherein a printed circuit board (50) with through holes (51) is placed in the housing (2) and covered by the cover (9C), wherein a free end portions (41) of each extension (40) of the body (13B) holding elements (13) of the second pair (12) reaches though the through holes (51) and is free within the through the holes (51) in the printed circuit board (50).

7. The mounting structure (3) according to claims 1 or 2, wherein a printed circuit board (50) has locking elements (42) mounted and a side (45) of the free end portions (41) of each extension (40) of the holding elements (13) of the second pair (12) abuts on the locking elements (42) when the printed circuit board (50) is placed in the housing part (9) of the housing (2).

8. The mounting structure (3) according to claim 1, wherein the cover (9C) carries the locking features (42) formed thereon and each locking feature (42) is in contact with a side (13S) of the body (13B) of the holding elements (13) of the second pair (12) when the cover (9C) is attached to the housing part (9), and wherein the locking features (42) reach through defined holes (51) of the printed circuit board (50).

9. The mounting structure (3) according to claim 1, wherein a printed circuit board (50) carries mounted locking features (42), and each locking feature (42) is in cooperation to a side (13S) of the body (13B) of each of the holding elements (13) of the second pair (12) when the printed circuit board (50) is attached to the housing part (9) and the locking features (42) limit a movement of the body (13B) of the holding elements (13) in a radial direction (D_{R}) way from the capacitor (4).

10. The mounting structure (3) according to claims 1 or 2, wherein the body (13B) of two opposing holding elements (13) of at least the second pair (12) has a flexed form and is defined by a first segment (13₁), a second segment (13₂) and a third segment (13₃); wherein the distance (D₁) between the first segments (13₁) of the holding elements (13) is larger than the distance (D₃) between the third segments (13₃) of the holding elements (13) and each of the third segments (13₃) carries the extension (40).

11. The mounting structure (3) according to claim 10, wherein the extension (40) passes through respective holes (51) in the printed circuit board (50) and a free end portions (41) of the extensions (40) are aligned with respective locking features (42) of the cover (9C).

12. The mounting structure (3) according to claims 10 or 11, wherein the mounted cover (9C) exerts a first force (61) perpendicular to the bottom (5) of the housing part (9) and thereby deforming the holding elements (13) and exerting a second force (62) on the capacitor (4).

13. An electronic control unit (1) for a vehicle (16) incorporating a mounting structure (3) for a capacitor (4) in a housing part (9) of the electronic control unit (1), wherein the mounting structure (3) is claimed in anyone of the preceding claims.

## Patentansprüche

1. Eine Befestigungsstruktur (3) zur Montage eines Kondensators (4) in einem Gehäuse (2)
**gekennzeichnet durch**
ein Gehäuseteil (9) des Gehäuses (2) mit einem Boden (5) und einer Abdeckung (9C),
wobei die Befestigungsstruktur (3) ein integraler Bestandteil des Bodens (5) des Gehäuseteils (9) ist und
die Befestigungsstruktur (3) mindestens durch ein erstes Paar (11) und ein zweites Paar (12) von zwei gegenüberliegenden Halteelementen (13) für den Kondensator (4) definiert ist,
mindestens ein Paar von Verriegelungsmerkmalen (42), die mit dem mindestens einen Paar von Halteelementen (13) zusammenwirken, um eine radiale Auslenkung (D_{R}) der gegenüberliegenden Halteelemente (13) zu begrenzen, wodurch der Kondensator (4) in der Befestigungsstruktur (3) gesichert wird.

2. Die Befestigungsstruktur (3) nach Anspruch 1, wobei jedes Halteelement (13) des zweiten Paares (12) durch einen Körper (13B) und eine Verlängerung (40) definiert ist, wobei die Verlängerung (40) eine Breite (W40) aufweist, die kleiner ist als eine Breite (W13) des Körpers (13B) der Halteelemente (13).

3. Die Befestigungsstruktur (3) nach Anspruch 1 oder 2, wobei eine gedruckte Leiterplatte (50) mit Durchgangslöchern (51) in dem Gehäuse (2) angeordnet und durch die Abdeckung (9C) abgedeckt ist, wobei jede Verlängerung (40) durch die Durchgangslöcher (51) reicht und an Verriegelungsmerkmalen (42) anliegt, die als Teil der Abdeckung (9C) ausgebildet sind.

4. Die Befestigungsstruktur (3) nach Anspruch 1 oder 2, wobei eine gedruckte Leiterplatte (50) mit Durchgangslöchern (51) in dem Gehäuse (2) angeordnet und durch die Abdeckung (9C) abgedeckt ist, wobei freie Endabschnitte (41) jeder Verlängerung (40) der Halteelemente (13) des zweiten Paares (12) in Eingriff mit den Durchgangslöchern (51) in der gedruckten Leiterplatte (50) stehen.

5. Die Befestigungsstruktur (3) nach Anspruch 4, wobei jeder der freien Endabschnitte (41) der Verlängerungen (40) eine hakenförmige Form (43) aufweist, die in Kontakt mit einer Lateralseite der Durchgangslöcher (51) der gedruckten Leiterplatte (50) ist.

6. Befestigungsstruktur (3) nach Anspruch 1 oder 2, wobei eine gedruckte Leiterplatte (50) mit Durchgangslöchern (51) in dem Gehäuse (2) angeordnet und durch die Abdeckung (9C) abgedeckt ist, wobei ein freier Endabschnitt (41) jeder Verlängerung (40) des Körpers (13B) der Halteelemente (13) des zweiten Paares (12) durch die Durchgangslöcher (51) hindurchreicht und innerhalb der Durchgangslöcher (51) in der gedruckten Leiterplatte (50) frei ist.

7. Die Befestigungsstruktur (3) nach Anspruch 1 oder 2, wobei an einer gedruckten Leiterplatte (50) Verriegelungsmerkmale (42) angebracht sind und eine Seite (45) der freien Endabschnitte (41) jeder Verlängerung (40) der Halteelemente (13) des zweiten Paares (12) an den Verriegelungsmerkmalen (42) anliegt, wenn die gedruckte Leiterplatte (50) in das Gehäuseteil (9) des Gehäuses (2) eingesetzt ist.

8. Die Befestigungsstruktur (3) nach Anspruch 1, wobei die Abdeckung (9C) die daran ausgebildeten Verriegelungsmerkmale (42) trägt und jedes Verriegelungsmerkmal (42) mit einer Seite (13S) des Körpers (13B) der Halteelemente (13) des zweiten Paares (12) in Kontakt steht, wenn die Abdeckung (9C) an dem Gehäuseteil (9) angebracht ist, und wobei die Verriegelungsmerkmale (42) durch definierte Löcher (51) der gedruckten Leiterplatte (50) reichen.

9. Die Befestigungsstruktur (3) nach Anspruch 1, wobei eine gedruckte Leiterplatte (50) montierte Verriegelungsmerkmale (42) trägt, und jedes Verriegelungsmerkmal (42) mit einer Seite (13S) des Körpers (13B) jedes der Halteelemente (13) des zweiten Paares (12) zusammenwirkt, wenn die gedruckte Leiterplatte (50) an dem Gehäuseteil (9) befestigt ist, und die Verriegelungsmerkmale (42) begrenzen eine Bewegung des Körpers (13B) der Halteelemente (13) in einer radialen Richtung (D_{R}) weg von dem Kondensator (4).

10. Die Befestigungsstruktur (3) nach Anspruch 1 oder 2, wobei der Körper (13B) von zwei gegenüberliegenden Halteelementen (13) zumindest des zweiten Paares (12) eine gebogene Form aufweist und durch ein erstes Segment (13₁), ein zweites Segment (13₂) und ein drittes Segment (13₃) definiert ist; wobei der Abstand (D₁) zwischen den ersten Segmenten (13₁) der Halteelemente (13) größer ist als der Abstand (D₃) zwischen den dritten Segmenten (13₃) der Halteelemente (13) und jedes der dritten Segmente (13₃) die Verlängerung (40) trägt.

11. Die Befestigungsstruktur (3) nach Anspruch 10, wobei die Verlängerung (40) durch entsprechende Löcher (51) in der gedruckten Leiterplatte (50) verläuft und freie Endabschnitte (41) der Verlängerungen (40) mit entsprechenden Verriegelungsmerkmalen (42) der Abdeckung (9C) ausgerichtet sind.

12. Die Befestigungsstruktur (3) nach Anspruch 10 oder 11, wobei die montierte Abdeckung (9C) eine erste Kraft (61) senkrecht zum Boden (5) des Gehäuseteils (9) ausübt und dadurch die Halteelemente (13) verformt und eine zweite Kraft (62) auf den Kondensator (4) ausübt.

13. Eine elektronische Steuereinheit (1) für ein Fahrzeug (16) mit einer Befestigungsstruktur (3) für einen Kondensator (4) in einem Gehäuseteil (9) der elektronischen Steuereinheit (1), wobei die Befestigungsstruktur (3) nach einem der vorhergehenden Ansprüche beansprucht wird.

## Revendications

1. Une structure de montage (3) pour monter un condensateur (4) dans un boîtier (2)
**caractérisée par**
une partie de boîtier (9) du boîtier (2) avec un fond (5) et un couvercle (9C),
dans laquelle la structure de montage (3) fait partie intégrante du fond (5) de la partie de boîtier (9) et
la structure de montage (3) est au moins définie par une première paire (11) et une deuxième paire (12) de deux éléments de maintien opposés (13) pour le condensateur (4),
au moins une paire d'éléments de verrouillage (42) interagissant avec la au moins une paire d'éléments de maintien (13) pour limiter une déviation radiale (D_{R}) des éléments de maintien (13) opposés et fixant ainsi le condensateur (4) dans la structure de montage (3).

2. La structure de montage (3) selon la revendication 1, dans laquelle chaque élément de maintien (13) de la deuxième paire (12) est défini par un corps (13B) et une extension (40), dans laquelle l'extension (40) a une largeur (W40) qui est inférieure à une largeur (W13) du corps (13B) des éléments de maintien (13).

3. La structure de montage (3) selon les revendications 1 ou 2, dans laquelle une carte de circuit imprimé (50) avec des trous traversants (51) est placée dans le boîtier (2) et recouverte par le couvercle (9C), dans laquelle chaque extension (40) traverse les trous traversants (51) et vient en butée contre des éléments de verrouillage (42) formés comme une partie du couvercle (9C).

4. La structure de montage (3) selon les revendications 1 ou 2, dans laquelle une carte de circuit imprimé (50) avec des trous traversants (51) est placée dans le boîtier (2) et recouverte par le couvercle (9C), dans laquelle des parties d'extrémité libres (41) de chaque extension (40) des éléments de maintien (13) de la deuxième paire (12) sont en prise avec les trous traversants (51) dans la carte de circuit imprimé (50).

5. La structure de montage (3) selon la revendication 4, dans laquelle chacune des parties d'extrémité libres (41) des extensions (40) présente une forme en crochet (43) qui est en contact avec un côté latéral des trous (51) de la carte de circuit imprimé (50).

6. La structure de montage (3) selon les revendications 1 ou 2, dans laquelle une carte de circuit imprimé (50) avec des trous traversants (51) est placée dans le boîtier (2) et recouverte par le couvercle (9C), dans laquelle une partie d'extrémité libre (41) de chaque extension (40) du corps (13B) des éléments de maintien (13) de la deuxième paire (12) traverse les trous traversants (51) et est libre à l'intérieur des trous traversants (51) dans la carte de circuit imprimé (50).

7. La structure de montage (3) selon les revendications 1 ou 2, dans laquelle une carte de circuit imprimé (50) comporte des éléments de verrouillage (42) montés et un côté (45) des parties d'extrémité libres (41) de chaque extension (40) des éléments de maintien (13) de la deuxième paire (12) vient en butée contre les éléments de verrouillage (42) lorsque la carte de circuit imprimé (50) est placée dans la partie de boîtier (9) du boîtier (2).

8. La structure de montage (3) selon la revendication 1, dans laquelle le couvercle (9C) porte les éléments de verrouillage (42) formés sur celui-ci et chaque élément de verrouillage (42) est en contact avec un côté (13S) du corps (13B) des éléments de maintien (13) de la deuxième paire (12) lorsque le couvercle (9C) est fixé à la partie de boîtier (9), et dans laquelle les éléments de verrouillage (42) traversent des trous (51) définis de la carte de circuit imprimé (50).

9. La structure de montage (3) selon la revendication 1, dans laquelle une carte de circuit imprimé (50) porte des éléments de verrouillage (42) montés, et chaque élément de verrouillage (42) coopère avec un côté (13S) du corps (13B) de chacun des éléments de maintien (13) de la deuxième paire (12) lorsque la carte de circuit imprimé (50) est fixée à la partie de boîtier (9) et les éléments de verrouillage (42) limitent un mouvement du corps (13B) des éléments de maintien (13) dans une direction radiale (D_{R}) à partir du condensateur (4).

10. La structure de montage (3) selon les revendications 1 ou 2, dans laquelle, le corps (13B) de deux éléments de maintien (13) opposés d'au moins la deuxième paire (12) a une forme fléchie et est défini par un premier segment (13₁), un deuxième segment (13₂) et un troisième segment (13₃); dans laquelle la distance (D₁) entre les premiers segments (13₁) des éléments de maintien (13) est supérieure à la distance (D₃) entre les troisièmes segments (13₃) des éléments de maintien (13) et chacun des troisièmes segments (13₃) porte l'extension (40).

11. La structure de montage (3) selon la revendication 10, dans laquelle l'extension (40) passe à travers des trous (51) respectifs dans la carte de circuit imprimé (50) et des parties d'extrémité libres (41) des extensions (40) sont alignées avec des éléments de verrouillage respectifs (42) du couvercle (9C).

12. La structure de montage (3) selon les revendications 10 ou 11, dans laquelle le couvercle (9C) monté exerce une première force (61) perpendiculaire au fond (5) de la partie de boîtier (9), déformant ainsi les éléments de maintien (13) et exerçant une deuxième force (62) sur le condensateur (4).

13. Une unité de commande électronique (1) pour un véhicule (16) comprenant une structure de montage (3) pour un condensateur (4) dans une partie de boîtier (9) de l'unité de commande électronique (1), dans laquelle la structure de montage (3) est revendiquée selon l'une quelconque des revendications précédentes.
